# EUROPEAN PATENT APPLICATION

(11) **EP 2 397 582 A1**
(43) Date of publication of application: **21.12.2011**
(21) Application number: 10741232.2
(22) Date of filing: 09.02.2010
(51) Int. Cl.: C30B 29/06, C03B 20/00, C30B 15/10

(54) **QUARTZ GLASS CRUCIBLE FOR PULLING SINGLE-CRYSTAL SILICON AND PROCESS FOR PRODUCING SINGLE-CRYSTAL SILICON**

(30) Priority: 10.02.2009 JP 2009028444
(71) Applicant: Kuramoto Co., Ltd., Miyagi 989-5508 (JP)
(72) Inventor: FUJISHIRO, Masaru, Ichinoseki-shi Iwate 029-3207 (JP); TAKAHASHI, Fumio, Ichinoseki-shi Iwate 029-3207 (JP); ABE, Fumihito, Ichinoseki-shi Iwate 029-3207 (JP); NAKAJIMA, Shinichi, Ichinoseki-shi Iwate 029-3207 (JP); TSUTSUI, Shinobu, Ichinoseki-shi Iwate 029-3207 (JP)
(74) Representative: Calamita, Roberto
(86) International application number: PCT/JP2010/051893
(87) International publication number: WO 2010/092955

(57) **Abstract**

The invention provides a quartz glass crucible for pulling up single-crystal silicon, and a method for producing single-crystal silicon by using it. The quartz glass crucible is **characterized by** having a crystallization promoter-containing layer as the inner surface thereof and is **characterized in that**, when single-crystal silicon is pulled up, macular crystallized regions are formed in the inner surface thereof by the action of the crystallization promoter. In the quartz glass crucible, a crystallized substance is not generated sparsely in the inner surface thereof and therefore does not shed off; outgassing holes are not generated through micro-peeling off of a part of the crystal layer formed in the inner surface thereof, unlike in a case where a crystal layer is formed entirely in the inner surface thereof; molten silicon does not penetrate into the area between the crystal layer and the underlying glass layer through the outgassing holes formed by micro-peeling off; and therefore the quartz glass crucible brings about a high yield.

## Description

### [Technical Field]

The present invention relates to a quartz glass crucible to be used in producing single-crystal silicon for use for substrates for solar cells, semiconductor devices, etc., and to a method for producing single-crystal silicon by using it.

### [Background Art]

Single-crystal silicon is produced from polycrystalline silicon according to an FZ method or a CZ method. In particular, at present, single-crystal silicon produced according to a CZ method takes a market share of at least 70%. In the CZ method, polycrystalline silicon is put into a quartz glass crucible, melted under heat therein, and single-crystal silicon is pulled up by the use of a seed crystal.

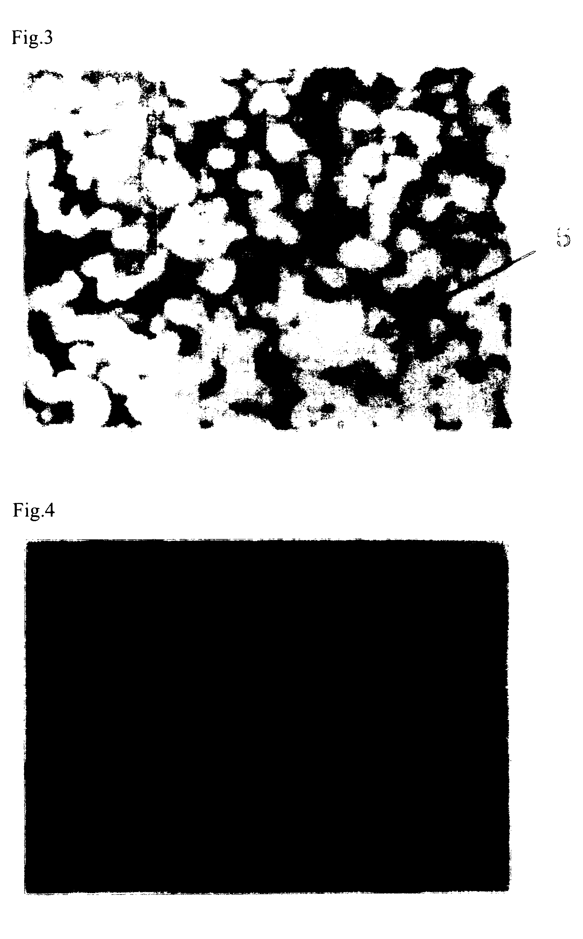

The quartz glass crucible is, as only one member that is kept in contact with molten silicon, an important member that determines the yield and the quality of single-crystal silicon. The yield of single-crystal silicon is lowered when the crystallized substance (Fig. 4) having a size of φ2 to φ6, which is generated through reaction of molten silicon and a quartz glass crucible at high temperature and sparsely exists in the interface therebetween, peels off from the inner surface of the quartz glass crucible and adheres to the edges of single-crystal silicon for polycrystallization. Accordingly, uniform crystallization of the entire inner surface of the quartz glass crucible is now under investigation.

For example, Patent Reference 1 discloses a method of applying high-concentration barium onto the entire inner surface of a quartz glass crucible to thereby crystallize the inner surface of the quartz glass crucible entirely into a thick crystal layer before use.

Patent Reference 2 discloses a method of increasing the pulling yield of single-crystal silicon by using the crucible of Patent Reference 1.

However, in the methods described in Patent References 1 and 2, relatively high-concentration barium coating is needed, in which, therefore, there may occur a problem in that barium mixing into the growing silicon crystal may form defects. Further, in case of large-diameter silicon crystal growth, severer heat environments are needed, and therefore the thickly-crystallized quartz glass crucible may be significantly deteriorated. In addition, use of high-concentration barium makes it difficult to handle the crucible.

Patent Reference 3 discloses a method of forming a coating film or a solid solution layer of a crystallization promoter within a depth of 1 mm of the inner surface of a quartz glass crucible, thereby enhancing the durability of the crucible. In case where a 2a Group element compound is used as the crystallization promoter, its solution is applied onto the inner surface of a crucible and dried to form a coating film thereon. On the other hand, in case where a 3b Group element compound is used as the crystallization promoter, a powder doped with it is scattered during melting to form a solid solution layer.

In these methods, however, the concentration of the crystallization promoter is too high, and therefore the crystal layer readily separates and peels off from the inner surface of the quartz glass crucible, and it is difficult to increase the yield in pulling up single-crystal silicon.

Patent Reference 4 discloses a quartz glass crucible, of which the crystallization promoter-containing layer of the inner surface hardly peels off, and which has high crucible strength at high temperature and can stably attain single-crystal silicon pulling.

However, for maintaining the high strength of the quartz glass crucible during pulling, the crystallization promoter-containing layer must be thick to be from 1 to 2 mm, and quartz powder in which the concentration of the crystallization promoter is gradually increased must be stepwise deposited to form multiple layers, and therefore it could not be said that the layer formation efficiency is good.

In addition, in this method, in case where the crystallization promoter has a low concentration and is used at low temperature for small diameter quartz glass crucibles, the crystallization speed is low and the crystallized substance generated in the inner surface of the quartz glass crucible may peel off and therefore it is difficult to stably increase the yield in pulling up single-crystal silicon.
- [Patent Reference 1]: JP-A 9-110590
- [Patent Reference 2]: JP-A 9-110579
- [Patent Reference 3]: JP-A 8-002932
- [Patent Reference 4]: JP-A 2007-001806

### [Disclosure of the Invention]

### [Problems that the Invention is to Solve]

In the above-mentioned prior-art techniques, for preventing the crystallized substance (Fig. 4) having a size of from φ2 to φ6 and generated sparsely in the inner surface of a quartz glass crucible, from shedding and dropping down, uniform crystallization of the inner surface is emphasized, but any effective solution is not proposed therein for preventing the excessively crystallized crystal layer from shedding off from the inner surface of the quartz glass crucible. Specifically, the present inventors' investigations have revealed that, in case where a crystal layer is formed entirely in the inner surface of a quartz glass crucible, the gases, for example, SiO, air in bubbles, gaseous impurities and the like existing inside the quartz glass crucible expanded at high temperature during pulling of single-crystal silicon would lose their escape route owing to the crystal layer formed by uniformly crystallizing the entire inner surface of the quartz glass crucible and, as a result, a large number of outgassing holes having a size of a few tens φm that are for discharging the gases existing inside the crucible are formed through micro-peeling off of a part of the crystal layer (Fig. 5, Fig. 6). Consequently, molten silicon may penetrate into the area between the crystal layer and the underlying glass layer (transparent layer or opaque layer) through the outgassing holes formed by micro-peeling off (Fig. 7, Fig. 8), thereby bringing about shedding of the crystal layer.

On the other hand, when the degree of crystallization is lowered due to fears of shedding of the crystal layer from the inner surface of the quartz glass crucible, then it may be impossible to prevent the crystallized substance having a size of from φ2 to φ6 and generated sparsely in the inner surface of the quartz glass crucible, from shedding and dropping down,

The present invention has been made inconsideration of the above-mentioned situation, and its object is to provide a quartz glass crucible, in which a crystallized substance is not generated sparsely in the inner surface thereof and therefore does not shed and drop down, in which outgassing holes are not generated through micro-peeling off of a part of the crystal layer formed in the inner surface thereof, unlike in a case where a crystal layer is formed entirely in the inner surface thereof, in which molten silicon does not penetrate into the area between the crystal layer and the underlying glass layer through the outgassing holes formed by micro-peeling off, and which therefore brings about a high yield, and to provide a method for producing single-crystal silicon by using the crucible.

### [Means for Solving the Problems]

For solving the above-mentioned problems, the invention is characterized by the following:

First: A quartz glass crucible for pulling up single-crystal silicon, characterized by having a crystallization promoter-containing layer as the inner surface thereof and characterized in that, when single-crystal silicon is pulled up, macular crystallized regions are formed in the inner surface thereof by the action of the crystallization promoter.

Second: The quartz glass crucible of the above first, wherein the macular crystallized regions are formed through continuous bonding of the crystallized substance sparsely generated in the inner surface of the quartz glass crucible during pulling of single-crystal silicon.

Third: The quartz glass crucible of the above first or second, wherein the macular crystallized regions include unit regions each having an independent form as the marginal part thereof is substantially closed and the area of the form falls within a range of from 10 to 100 mm².

Fourth: The quartz glass crucible of the above third, wherein at least a part of the unit regions of the macular crystallized regions are further bonded continuously to each other, and the total area of the macular crystallized regions accounts for from 30 to 80% of the inner surface of the quartz glass crucible.

Fifth: The quartz glass crucible of the above fourth, wherein in the macular crystallized regions, microholes of from 10 to 100 µm in size are not generated during pulling of single-crystal silicon.

Sixth: The quartz glass crucible of any of the above first to fifth, wherein the crystallization promoter is at least one 2a Group element selected from magnesium, strontium, calcium and barium.

Seventh: The quartz glass crucible of any of the above first to sixth, wherein the crystallization promoter is barium, and the crystallization promoter-containing layer is formed by applying a barium-coated high-purity silica powder onto the inner surface of the quartz glass crucible and melting it thereon.

Eighth: The quartz glass crucible of the above seventh, wherein the crystallization promoter-containing layer has a thickness of from 30 to 200 µm.

Ninth: The quartz glass crucible of the above seventh or eighth, wherein the crystallization promoter-containing layer has a barium concentration of from 100 to 200 ppm.

Tenth: The quartz glass crucible of any of the above seventh to ninth, wherein the crystallization promoter-containing layer has a barium concentration of from 130 to 170 ppm.

Eleventh: A method for producing single-crystal silicon by using the quartz glass crucible of any of the above first to tenth, characterized by comprising a step of putting polycrystalline silicon into the quartz glass crucible, a step of heating and melting the polycrystalline silicon to form a molten silicon liquid, and a step of pulling up single-crystal silicon from the molten silicon liquid in the quartz glass crucible by using a seed crystal.

### [Advantage of the Invention]

According to the invention, during pulling of single crystal, a crystallized substance is not sparsely generated in the inner surface of the quartz glass crucible, and macular crystallized regions of a crystallized substance continuously bonding to each other are formed therein. In that manner, macular crystallized regions are formed and therefore, the crystallized substance as sparsely generated in the inner surface of the quartz glass crucible is prevented from shedding off. In particular, since the quartz glass crucible has a crystallization promoter in the depth direction of the inner surface thereof, the crystallization of the macular crystallized regions is promoted in the depth direction of the inner surface. Accordingly, the crystallized substance sparsely generated in the inner surface of the crucible can be significantly prevented from shedding off.

Further, during pulling of single-crystal silicon, gases existing inside the quartz glass crucible can be discharged away from the other regions than the macular crystallized regions in the inner surface of the quartz glass crucible. Therefore, the crystal layer in the macular crystallized regions does not micro-peeling off to form outgassing holes, and the molten silicon does not penetrate into the area between crystal layer and the underlying glass layer in the macular crystallized regions. Accordingly, the crystal layer in the macular crystallized region does not shed off.

As in the above, a crystallized substance is not sparsely generated in the inner surface of the quartz glass crucible of the invention to drop off, unlike before, and a part of the crystallized layer does not micro-peeling off to form outgassing holes, unlike in a case where a crystal layer is formed entirely in the inner surface thereof, and molten silicon does not penetrate into the area between the crystal layer and the underlying glass layer through the outgassing holes formed by micro-peeling off. Accordingly, the invention provides the quartz glass crucible capable of pulling up single-crystal silicon at an extremely high yield.

### [Brief Description of the Drawings]

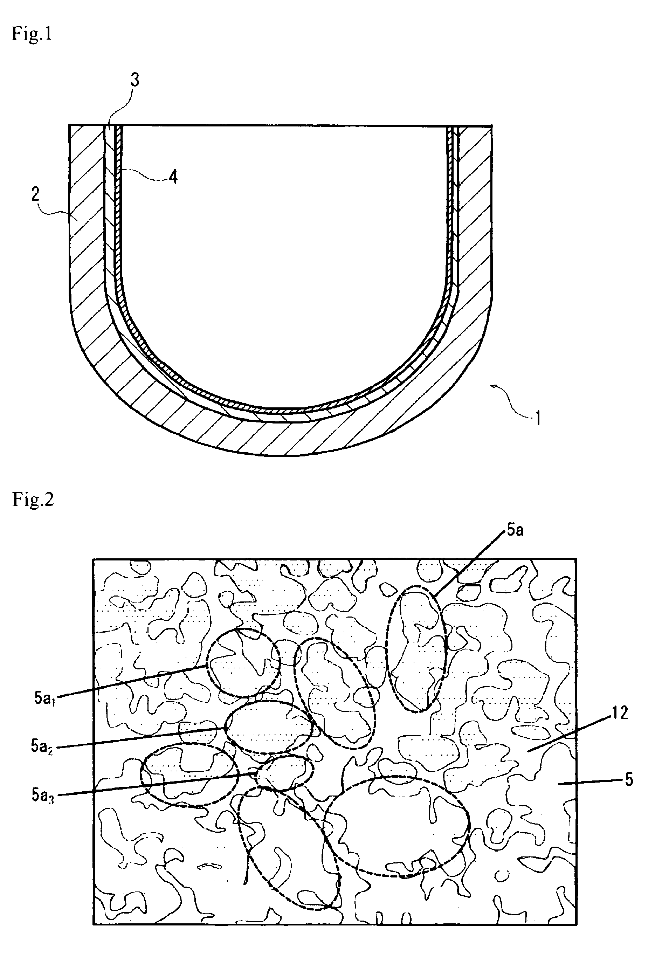

[Fig. 1] This is a cross-sectional view schematically showing one embodiment of a quartz glass crucible for pulling up single-crystal silicon of the invention.
[Fig. 2] This is a view graphically showing the inner surface of a quartz glass crucible with macular crystallized regions formed therein.
[Fig. 3] This is a photograph of the inner surface of a quartz glass crucible of Example with macular crystallized regions formed therein after pulling up of single-crystal silicon by the use of the quartz glass crucible.
[Fig. 4] This is a photograph of a crystallized substance having a size of from φ2 to φ6 generated in the inner surface of a quartz glass crucible of Comparative Example.

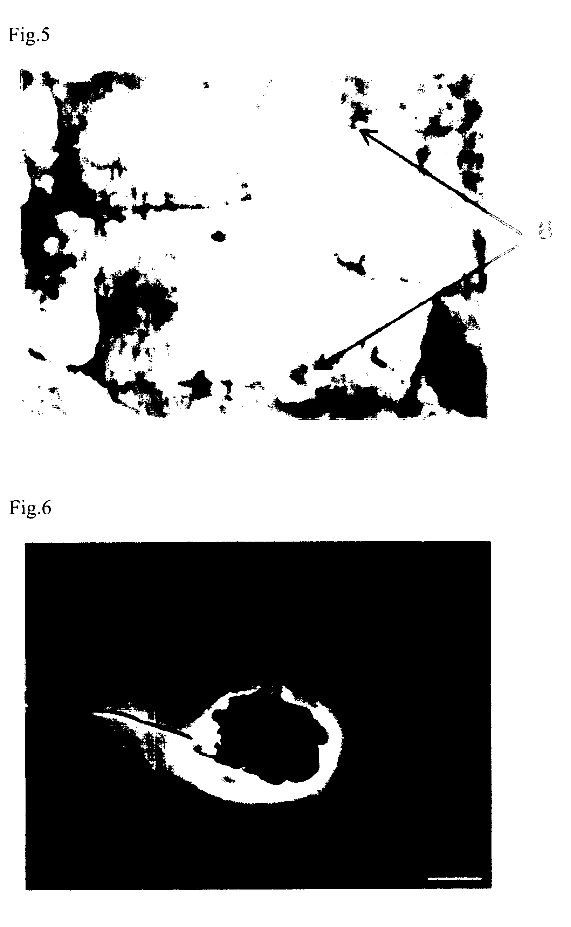

[Fig. 5] This is a photograph of outgassing holes of a few tens µm in size generated in the crystallized layer surface of the inner surface of a quartz glass crucible of Comparative Example.
[Fig. 6] This is an electromicroscopic photograph of outgassing holes of a few tens µm in size generated in the crystallized layer surface of the inner surface of a quartz glass crucible of Comparative Example.

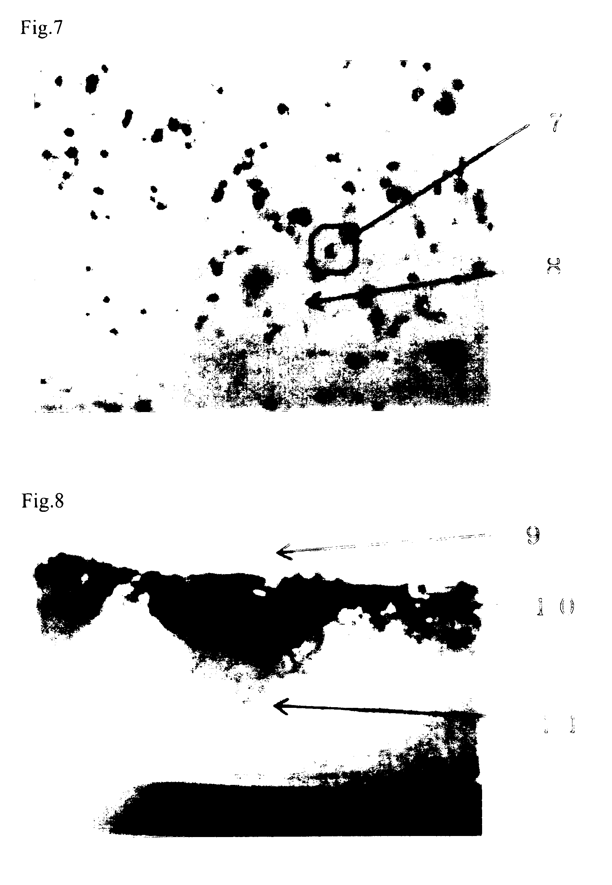

[Fig. 7] This is a photograph showing a condition where molten silicon has flowed into the area beneath the crystallized layer through outgassing holes of about 10 µm in size generated in a quartz glass crucible of Comparative Example.
[Fig. 8] This is a photograph showing a condition where molten silicon has flowed into the area beneath the crystallized layer and the opaque layer of quartz glass and the crystallized layer has peeled off from the opaque layer of quartz glass, as generated in a quartz glass crucible of Comparative Example.

### [Description of Reference Numerals and Signs]

- 1: Quartz Glass Crucible
- 2: Opaque Layer of Quartz Glass
- 3: Transparent Layer of Quartz Glass
- 4: Crystallization Promoter-Containing Layer
- 5: Macular Crystallization Region
- 5a: Unit Region
- 6: Outgassing Hole
- 7: Silicon
- 8: Surface of Crystal Layer
- 9: Crystal Layer
- 10: Silicon
- 11: Opaque Layer of Quartz Glass
- 12: Region except Macular Crystallization Region

### [Best Mode for Carrying out the Invention]

The invention is described in detail hereinunder.

Fig. 1 is a cross-sectional view schematically showing one embodiment of a quartz glass crucible for pulling up single-crystal silicon of the invention. As illustrated in the drawing, the quartz glass crucible 1 of the invention has a crystallization promoter-containing layer 4 as the inner surface thereof.

The crystallization promoter to be contained in the crystallization promoter-containing layer in the invention is one that promotes, in pulling up of single-crystal silicon, the reaction of the inner surface of the quartz glass crucible and a high-temperature molten silicon liquid and the formation of a crystallized substance in the interface therebetween; and its specific examples include Group 2a elements of magnesium, strontium, calcium, barium, etc. One or more of these may be used here either singly or as combined.

Of those crystallization promoters, barium has a small segregation coefficient and therefore has an excellent characteristic that it is hardly taken in the single-crystal silicon in pulling it up; and accordingly, use of barium as the crystallization promoter in the invention is especially preferred.

One characteristic feature of the invention is that, during pulling up of single-crystal silicon, macular crystallized regions are formed in the inner surface of the crucible by the action of the crystallization promoter.

In this, the macular crystallized regions are described with reference to the graphic view of Fig. 2 and the photograph of Fig. 3. In Fig. 2 and Fig. 3, the reference numeral 5 is the macular crystallized region.

The macular crystallized region is formed through continuous bonding of the crystallized substance generated sparsely in the inner surface of the quartz glass crucible in pulling up of single-crystal silicon, and this definitely differs from heretofore-known sparsely-generated crystallized substances in point of the form and the size thereof.

Specifically, the sparsely-generated crystallized substance is typically a circular one having a size of from φ2 to φ6, as shown in Fig. 4, and as compared with those of the macular crystallized region in the invention, the form and the size thereof each are within a given region and have a given regularity. Most of the sparsely-generated crystallized substances have an area of less than 10 mm².

As opposed to this, the macular crystallized region in the invention has an irregular and nonuniform outward appearance as a whole. As graphically shown in Fig. 2, the macular crystallized region 5 includes a unit region 5a having an independent form as the marginal part thereof is substantially closed, such as typically one surrounded by the dotted-line oval in the drawing.

As shown in the photograph of Fig. 3, the macular crystallized regions are irregular and nonuniform; and as shown in Fig. 2 as one example thereof, the regions include a plurality of unit regions 5a, such as unit region 5a₁, unit region 5a₂, unit region 5a₃, etc., as continuously communicating with each other via a thin part therebetween; however, as a matter of visual convenience, the unit region 5a can be so understood that it can be recognized as an independent form that is formed by substantially closing the marginal part thereof.

The unit region is formed as a result of reaction of a high-temperature molten silicon liquid with the inner surface of the quartz glass crucible in pulling up of single-crystal silicon, followed by continuous bonding of the crystallized substance generated in the interface through the reaction, by the action of the crystallization promoter contained in the inner surface of the quartz glass crucible. Specifically, the above-mentioned circular crystallized substances of from φ2 to φ6 in size are continuously bonded to each other to expand the unit region, and the unit region is therefore obviously larger than the size of the crystallized substance. The unit region typically includes one having an area falling within a range of from 10 to 100 mm². The unit region may include any others each having an area of more than 100 mm².

By continuously bonding the crystallized substance in the inner surface of the quartz glass crucible to form nonuniform macular crystallized regions, and further by making a crystallization promoter exist in the depth direction of the inner surface of the quartz glass crucible, the crystallization in the inner surface of the quartz glass crucible may be thereby promoted in the depth direction and the crystallized substance generated in the inner surface can be thereby prevented from shedding off. Forming the nonuniform macular crystallized regions in the inner surface of the quartz glass crucible makes it possible to discharge the gases existing inside the quartz glass crucible, through the other region 12 than the macular crystallized regions in Fig. 2, during pulling of single-crystal silicon, and therefore the crystal layer in the macular crystallized regions can be prevented from shedding off from the inner surface of the quartz glass crucible.

In one preferred embodiment of the invention, at least a part of the unit regions of the macular crystallized regions, for example, the unit region 5a₁, the unit region 5a₂, the unit region 5a₃ and the like shown in Fig. 2, are further bonded continuously to each other, and the total area of the macular crystallized regions accounts for from 30 to 80%, preferably from 30 to 70% of the inner surface of the quartz glass crucible.

In case where the total area of the macular crystallized regions is less than 30% of the inner surface of the quartz crucible, a large number of circular crystallized substances of from φ2 to φ6 in size may exist in the inner surface and they may frequently shed off in pulling of single-crystal silicon, whereby the single crystal pulling yield may lower.

On the other hand, when the total area of the macular crystallized regions is more than 80% of the inner surface of the quartz crucible, then the gases existing inside the quartz glass crucible and having expanded at high temperature could not be fully discharged out, during pulling of single-crystal silicon. In such a case, the gases may micro-peel off the crystal layer to form outgassing holes, and the gases may be discharged out through the outgassing holes (Fig. 6). In this, the present inventors have confirmed the formation of a large number of outgassing microholes of a few tens µm in size in the crystal layer (Fig. 5).

The hot molten silicon put in the quartz glass crucible may flow into the glass layer (transparent layer or opaque layer around it) of the quartz glass crucible existing below the crystal layer, through the outgassing microholes of a few tens µm in size (Fig. 7), and the glass layer is melted by the high-temperature molten silicon, and as a result, the molten silicon penetrates into the area between the crystal layer and the glass layer and the crystal layer sheds away from the quartz glass crucible (Fig. 8).

In one preferred embodiment of the invention, the crystallization promoter is barium, and the crystallization promoter-containing layer is formed by applying a barium-coated high-purity silica powder onto the inner surface of the quartz crystal crucible and melting it thereon. Thus formed, the thickness of the crystallization promoter-containing layer is preferably from 30 to 200 µm. When barium is contained within the thickness range and when the crystallization is promoted in the depth direction of the inner surface of the quartz glass crucible, then the crystallized substances generated in the inner surface can be prevented from shedding off.

In case where the crystallization promoter is contained in the depth of less than 30 µm from the inner surface, the crystallization could not be promoted when the crystallization promoter is contained in a high concentration therein, like in the case where the agent is applied onto the inner surface, and therefore crystallized substances generated in the inner surface would shed off.

In case where the crystallization promoter is contained in the depth of more than 200 µm from the inner surface, the crystallization may be promoted and the inner surface of the quartz glass crucible may be entirely crystallized, and if so, nonuniform macular regions could not be formed. Accordingly, the crystal layer sheds off from the inner surface of the quartz glass crucible.

Regarding the crystallization promoter content, the barium concentration is preferably from 100 to 200 ppm, more preferably from 130 to 170 ppm.

When the barium concentration is less than 100 ppm, then the concentration of barium as the crystallization promoter is low and therefore the crystallization could not be promoted, and the crystallized substances generated in the inner surface of the quartz glass crucible may shed off.

When the barium concentration is more than 200 ppm, then the crystallization may be promoted too much and the entire inner surface of the quartz glass crucible may be crystallized so that macular crystallized regions could not be formed. In such a case, the crystal layer may shed off from the inner surface of the quartz glass crucible.

On the other hand, when the barium concentration in the crystallization promoter-containing layer is from 130 to 170 ppm, then macular crystallized regions could be surely formed in a range of from 30 to 80% of the inner surface of the quartz glass crucible. Specifically, of the condition in pulling of single-crystal silicon, the quantity of heat to be given to the quartz glass crucible differs depending on the diameter size of the quartz glass crucible, etc. The condition of the macular crystallized regions in the inner surface of the quartz glass crucible may be influenced by the quantity of heat to be given to the quartz glass crucible, and therefore, for surely forming nonuniform macular crystallized regions in a range of from 30 to 80% of the inner surface, not depending on the condition in pulling of single-crystal silicon, barium must be distributed in the crystallization promoter-containing layer in a concentration of from 130 to 170 ppm therein. For example, in a case where on the diameter size of the quartz glass crucible is 16 inches, macular crystallized regions can be surely formed in a range of from 30 to 80% of the inner surface when the barium concentration is from 130 to 200 ppm. On the other hand, in a case where on the diameter size is 24 inches, macular crystallized regions can be surely formed in a range of from 30 to 80% of the inner surface when the barium concentration is from 100 to 170 ppm.

Using the quartz glass crucible of the invention described above, for example, it is possible to produce a single-crystal silicon ingot that may be a base material of a silicon substrate for use in solar cells or semiconductor devices, according to heretofore-known ordinary conditions. Specifically, one ordinary production method for a single-crystal silicon ingot using the quartz glass crucible is as follows: A necessary amount of polycrystalline silicon is filled in the quartz glass crucible, then the single-crystal silicon pulling device is replaced with argon gas, and heated up to 1420°C or higher, for example, up to from 1500°C to 1600°C by a graphite heat generator to melt the polycrystalline silicon. Then, the temperature is gradually lowered so that the temperature of the surface of the molten liquid could reach 1420°C, and thereafter a seed crystal (prismatic body of from 6 to 8 mm in size) is dipped in the molten liquid so that the surface of the seed crystal is thereby melted. For removing the dislocation having existed in the seed crystal or the dislocation newly generated by the thermal shock in seeding, a thin and long neck part having a diameter of from 3 to 5 mm and a length of from 100 to 300 mm is formed at a relatively high pulling up speed (1 to 5 mm/min). With lowering the temperature around the upper surface of the molten liquid in the quartz glass crucible, the pulling up speed is lowered to from 0.1 to 0.5 mm/min, whereupon a shoulder part having a drastically increasing diameter is formed from the thin-diameter neck part to the constant-diameter part thereof having a predetermined diameter within a short period of time. By controlling the temperature and the pulling up speed, the constant-diameter part of the crystal is grown so as to have a constant crystal diameter. When the crystal has reached a predetermined length, the temperature is lowered a little and the pulling up speed is increased so as to thin the crystal, whereby the diameter of the crystal is gradually decreased from the constant-diameter part thereof, and a tail having a diameter of zero is formed. When the single-crystal silicon ingot has separated from the molten liquid, the pulling up operation is finished, and single-crystal silicon can be produced at a high yield.

### [Examples]

The invention is described in more detail with reference to the following Examples; however, the invention is not whatsoever restricted by these Examples.

### <Examples>

A natural quartz powder was put into a rotating mold, then a voltage was applied to the graphite electrode, and an opaque layer of a quartz glass crucible was formed from the inner surface of the mold by current-applying electric arc heating. Subsequently, a natural quartz powder was gradually diffused and supplied in the arc flame to form a transparent layer. Further continuously, a barium-coated natural quartz powder, which had been prepared by coating a natural quartz powder with a solution of barium serving as the crystallization promoter in the invention, was gradually scattered and supplied to form a crystallization promoter-containing layer, and the melting operation was thus finished. Afterwards, a quartz glass crucible having an opaque quartz glass layer 2 in the outer peripheral part thereof, a transparent quartz glass layer 3 inside it and a crystallization promoter-containing layer 4 further inside it, as shown in Fig. 1, was produced according to a known process,.

With the thickness of the crystallization promoter-containing layer varied in three stages within a range of from 30 to 200 µm, and with the barium concentration in the crystallization promoter-containing layer varied in four stages within a range of from 100 to 200 ppm, quartz glass crucibles having a diameter size of 16 inches or 24 inches were thus produced.

Thus produced, the quartz glass crucibles having a diameter size of 16 inches or 24 inches were tried for pulling of single-crystal silicon, and as a result, macular crystallized regions were formed in the inner surface in pulling. The macular crystallized regions had, as shown in Fig. 2, an irregular and nonuniform appearance as a whole, and included unit regions having an area of from 10 to 100 mm². At least a part of the unit regions of the macular crystallized regions were further bonded continuously to each other, and the total area of the macular crystallized regions accounted for from 30 to 80% of the inner surface of the quartz crucible.

In all of the quartz glass crucibles of these Examples, the crystallized substances generated in the inner surface were prevented from shedding off, and the crystal layer did not shed off from the inner surface of the quartz glass crucible since outgassing holes were not formed, and a high single crystal formation yield of 75% or more was attained. The results are shown in Table 1.

### <Comparative Examples>

Quartz glass crucibles having a diameter size of 16 inches or 24 inches were produced in the same manner as in Examples, except that the thickness of the crystallization promoter-containing layer was 10 µm or 220 µm and the barium concentration in the crystallization promoter-containing layer was 0 ppm, 70 ppm or 230 ppm. The quartz glass crucibles were tried for pulling of single-crystal silicon. The results are shown in Table 1.

When the thickness of the crystallization promoter-containing layer was 10 µm and was less than 30 µm, a large number of crystallized substances having a size of from φ2 to φ6, which form in the presence of no crystallization promoter, formed in the inner surface of the quartz glass crucible, and the crystallized substances shed off from the inner surface of the quartz glass crucible. Accordingly, the single crystal pulling yield could not be increased.

When the thickness of the crystallization promoter-containing layer was 220 µm and was more than 200 µm, nearly a whole of more than 80% of the inner surface of the quartz glass crucible crystallized, and a large number of outgassing holes, which are small holes of a few tens µm in size, were seen in the surface of the crystal layer, and molten silicon penetrated into the area between the crystal layer and the opaque layer through the outgassing holes (Fig. 7). Accordingly, the single crystal pulling yield could not be increased.

When the diameter size of the quartz glass crucible was 16 inches and the barium concentration in the crystallization promoter-containing layer was less than 130 ppm, or when the diameter size of the quartz glass crucible was 24 inches and the barium concentration in the crystallization promoter-containing layer was less than 100 ppm, a large number of crystallized substances having a size of from φ2 to φ6, which form in the presence of no crystallization promoter, formed in the inner surface of the quartz glass crucible, and the crystallized substances shed off from the inner surface of the quartz glass crucible. Accordingly, the single crystal pulling yield could not be increased.

When the diameter size of the quartz glass crucible was 16 inches and the barium concentration in the crystallization promoter-containing layer was more than 200 ppm, or when the diameter size of the quartz glass crucible was 24 inches and the barium concentration in the crystallization promoter-containing layer was more than 170 ppm, nearly a whole of more than 80% of the inner surface of the quartz glass crucible crystallized, and a large number of outgassing holes, which are small holes of a few tens µm in size, were seen in the surface of the crystal layer, and molten silicon penetrated into the area between the crystal layer and the opaque layer through the outgassing holes (Fig. 7). Accordingly, the single crystal pulling yield could not be increased.

**[Table 1]**

| | | | Crystallization Promoter (barium) Concentration (ppm) | | | | | | |
|---|---|---|---|---|---|---|---|---|---|
| | | | 0 | 70 | 100 | 130 | 170 | 200 | 230 |
| 16 inches | Thickness of Crystallization Promoter-Containing Layer (µm) | 10 | △ | △:a | - | △:a | - | △:b | - |
| | | 30 | | - | △:a | O:b | O:b | O:b | O:b |
| | | 100 | | △:a | △:b | O:b | O:b | O:b | O:c |
| | | 200 | | - | O:b | O:b | O:b | O:b | X:c |
| | | 220 | | O:b | - | O:b | - | X:c | - |
| 24 inches | Thickness of Crystallization Promoter-Containing Layer | 10 | △ | △:a | - | △:a | - | △:b | - |
| | | 30 | | - | O:b | O:b | O:b | O:b | - |
| | | 100 | | △:a | O:b | O:b | O:b | O:c | X:c |
| | | 200 | | - | O:b | O:b | O:b | X:c | - |
| | | 220 | | O:b | - | O:b | - | - | - |

| | | | | | | | | | |
|---|---|---|---|---|---|---|---|---|---|
| O: No crystal layer shedding, single crystal yield 75% or more. △: No crystal layer shedding, single crystal yield less than 75%. X: Outgassing holes (Fig. 4, Fig. 5) confirmed, or crystal layer partly shed. Single crystal yield less than 75%. Area of crystallized region in the inner surface: a from 0 to less than 30%, b from 30 to less than 80%, c 80% or more. | | | | | | | | | |

## Claims

1. A quartz glass crucible for pulling up single-crystal silicon, **characterized by** having a crystallization promoter-containing layer as the inner surface thereof and **characterized in that**, when single-crystal silicon is pulled up, macular crystallized regions are formed in the inner surface thereof by the action of the crystallization promoter.

2. The quartz glass crucible as claimed in claim 1, wherein the macular crystallized regions are formed through continuous bonding of the crystallized substance sparsely generated in the inner surface of the quartz glass crucible during pulling of single-crystal silicon.

3. The quartz glass crucible as claimed in claim 1 or 2, wherein the macular crystallized regions include unit regions each having an independent form as the marginal part thereof is substantially closed and the area of the form falls within a range of from 10 to 100 mm².

4. The quartz glass crucible as claimed in claim 3, wherein at least a part of the unit regions of the macular crystallized regions are further bonded continuously to each other, and the total area of the macular crystallized regions accounts for from 30 to 80% of the inner surface of the quartz glass crucible.

5. The quartz glass crucible as claimed in claim 4, wherein in the macular crystallized regions, micro holes of from 10 to 100 µm in size are not generated during pulling of single-crystal silicon.

6. The quartz glass crucible as claimed in any of claims 1 to 5, wherein the crystallization promoter is at least one 2a Group element selected from magnesium, strontium, calcium and barium.

7. The quartz glass crucible as claimed in any of claims 1 to 6, wherein the crystallization promoter is barium, and the crystallization promoter-containing layer is formed by applying a barium-coated high-purity silica powder onto the inner surface of the quartz glass crucible and melting it thereon.

8. The quartz glass crucible as claimed in claim 7, wherein the crystallization promoter-containing layer has a thickness of from 30 to 200 µm.

9. The quartz glass crucible as claimed in claim 7 or 8, wherein the crystallization promoter-containing layer has a barium concentration of from 100 to 200 ppm.

10. The quartz glass crucible as claimed in any of claims 7 to 9, wherein the crystallization promoter-containing layer has a barium concentration of from 130 to 170 ppm.

11. A method for producing single-crystal silicon by using the quartz glass crucible of any of claims 1 to 10, **characterized by** comprising a step of putting polycrystalline silicon into the quartz glass crucible, a step of heating and melting the polycrystalline silicon to form a molten silicon liquid, and a step of pulling up single-crystal silicon from the molten silicon liquid in the quartz glass crucible by using a seed crystal.
